Europäisches Patentamt

European Patent Office

Office européen des brevets

(11) Veröffentlichungsnummer: **0 400 399**

**A2**

## (12) EUROPÄISCHE PATENTANMELDUNG

(21) Anmeldenummer: **90109257.7**

(22) Anmeldetag: **16.05.90**

(51) Int. Cl.⁵: **H01L 27/144**

(30) Priorität: **31.05.89 DE 3917703**

(43) Veröffentlichungstag der Anmeldung:
**05.12.90 Patentblatt 90/49**

(84) Benannte Vertragsstaaten:
**DE FR GB IT**

(71) Anmelder: **Siemens Aktiengesellschaft**
**Wittelsbacherplatz 2**
**D-8000 München 2(DE)**

(72) Erfinder: **Lauterbach, Christl**
**Rosenstrasse 6**
**D-8011 Siegertsbrunn(DE)**
Erfinder: **Albrecht, Helmut, Dr.-Ing.**
**Wessobrunner Platz 9a**
**D-8000 München 70(DE)**

(54) **Monolitisch intergrierte Photodiode-FET-Kombination.**

(57) Photodiode-FET-Kombination mit optimierter Schichtstruktur, bei der die Photodiode (16) und der FET (15) durch einen Trenngraben (14) voneinander getrennt und durch einen pn-Übergang bildende Sperrschichten (2, 3) zur Vermeidung von Nebenflußströmen vom Substrat getrennt sind, wobei die Schichtfolge aus einer ganzflächig aufgewachsenen Absorptionsschicht (4), einer ebenfalls ganzflächig aufgewachsenen, im Bereich der Photodiode (16) auf den Bereich des Lichteinfalles rückgeätzten Photodiodensicht (5) und im Bereich des FET (15) einer Kanalschicht (6) und einer das Gate bildenden Deckschicht (7) besteht.

EP 0 400 399 A2

## Monolithisch integrierte Photodiode-FET-Kombination

Die Entwicklung optischer Datenübertragungssysteme geht dahin, für die Verbindung zwischen optischen und elektronischen Komponenten integrierte optoelektronische Schaltkreise einzusetzen. Auf der Empfängerseite stellt sich das Problem der Integration von Photodetektor und Vorverstärker. Gefordert werden gute Kompatibilität der für die verschiedenen Komponenten benötigten Halbleiterschichten und Herstellungstechniken. Ein monolithisch integrierter planarer Baustein, der auf einem Halbleitersubstrat eine Photodiode und einen Feldeffekttransistor (FET) enthält und der die unterschiedlichen Anforderung an Dotierungskonzentration und Schichtdicke berücksichtigt, ist in H. Albrecht, Ch. Lauterbach: "Monolithically Integrated InGaAs/InP:Fe Photodiode-Junction Field-Effect Transistor Combination", Siemens Forschungs- u. Entwicklungsberichte 17, 195-198, (1988) angegeben.

Eine optimierte Photodiode benötigt für einen hohen externen Quantenwirkungsgrad eine ausreichend dicke Absorptionsschicht aus n-InGaAs mit geringer Restdotierung. Diese nominell undotierte InGaAs-Schicht ist Voraussetzung für eine niedrige Kapazität sowie geringen Dunkelstrom und demzufolge gute Rauscheigenschaften. Eine hochdotierte n-leitende Halbleiterschicht (z. B. InGaAs oder InAlAs oder InP) auf dem InP:Fe-Substrat reduziert den Serienwiderstand und die Laufzeiteffekte, d. h. die Trägertransitzeit der Photodiode.

Der FET benötigt für eine hohe Steilheit eine hochdotierte $n^+$-InGaAs-Schicht, die für ein gutes Abschnürverhalten des FETs entsprechend dünn sein muß. Die Deckschicht aus n-InP bzw. n-InAlAs bildet zum InGaAs eine Heterobarriere und ermöglicht die Realisierung eines sperrenden Metallhalbleiterübergangs als Gate, bzw. zusammen mit einer p-Diffusion oder p-Implantation die Herstellung eines Sperrschicht-Gates. Diese Schicht hat außerdem den Vorteil, daß aufgrund des höheren Bandabstandes von InP bzw. InAlAs im Vergleich zu InGaAs eine Passivierung des pn-Überganges an der Bauelementeoberfläche die Langzeitstabilität erhöht und Leckströme verringert. Dieser Vorteil ergibt sich sowohl für die Photodiode als auch für den FET.

Aufgabe der vorliegenden Erfindung ist es, eine monolithisch integrierte Photodiode-FET-Kombination mit einer für einfache Herstellbarkeit und gute Funktionsfähigkeit gleichermaßen optimierten Halbleiterschichtstruktur anzugeben.

Diese Aufgabe wird mit einer Photodiode-FET-Kombination mit den Merkmalen des Anspruches 1 gelöst. Die zusätzlichen Merkmale des Anspruchs 2 ergeben eine besonders vorteilhafte Ausgestaltung.

Die erfindungsgemäße Halbleiterschichtstruktur hat den Vorteil, daß sämtliche notwendigen Dotierungen und Schichtdicken auf einem planaren semiisolierenden InP-Substratkristall ganzflächig mit Epitaxieverfahren wie z. b. VPE, MOVPE, MBE oder MOMBE in einem Arbeitsgang hergestellt werden können.

Bei der nachfolgenden Chiptechnologie werden die selektiven Ätzeigenschaften der unterschiedlichen Mischkristallschichten ausgenutzt, um gezielt bestimmte Schichten freizulegen und zu kontaktieren. Es sind so bei optimierten Schichtfolgen für beide Bauelemente keine selektiven Dotierschritte wie z. B. Diffusion oder Ionenimplantation nach der Epitaxie der Schichten mehr notwendig und es entfallen somit Hochtemperaturprozesse, die die Eigenschaften von epitaktisch gewachsenen Heteroschichten und Dotierprofilen verschlechtern können.

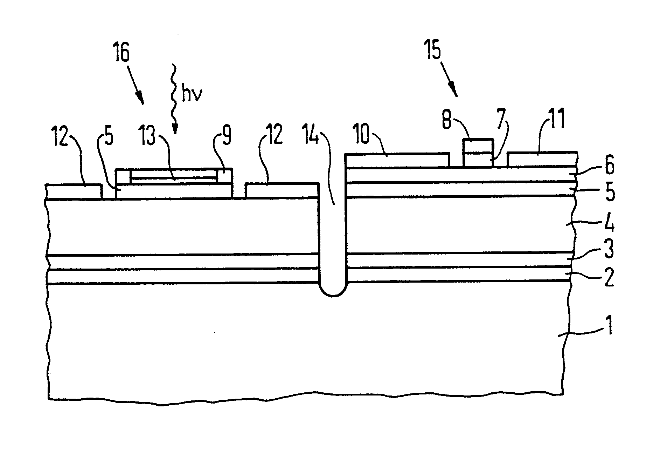

Es folgt eine Beschreibung der erfindungsgemäßen Photodiode-FET-Kombination anhand des in der Figur dargestellen Querschnittes.

Bei einer besonders vorteilhaften Ausgestaltung der erfindungsgemäßen Photodiode-FET-Kombination sind auf einem Substrat 1 aus z. B. semiisolierendem Indiumphosphid nacheinander eine erste Sperrschicht 2 und eine zweite Sperrschicht 3 aufgewachsen. Diese Sperrschichten 2, 3 können jeweils aus InP, oder InAlAs oder InGaAlAs bestehen. Die erste Sperrschicht 2 ist p-dotiert mit einer Akzeptorendichte von $N_A = 10^{15} ... 10^{18}$ cm$^{-3}$; die zweite Sperrschicht 3 ist n-dotiert und weist eine Donatorendichte $N_D = 10^{16} ... 10^{18}$ cm$^{-3}$ auf. Die erste Sperrschicht hat eine Dicke von etwa 0,2 bis 2 μm; die zweite Sperrschicht 3 hat eine Dicke von etwa 0,2 bis 3 μm. Diese Sperrschichten 2, 3 bilden einen sperrenden pn-Übergang, der zusammen mit einem zwischen der Photodiode und dem FET befindlichen Trenngraben 14, der bis in das Substrat 1 hineinreicht, Leckströme über das semiisolierende Substrat 1 vermindert. Zusätzlich reduziert die zweite Sperrschicht 3 Laufzeiteffekte und Serienwiderstand bei der Photodiode.

Über dieser zweiten Sperrschicht 3 ist eine Absorptionsschicht 4 ganzflächig aufgewachsen. Diese Absorptionsschicht 4 besteht z. B. aus InGaAs und ist nominell undotiert (Donatorendichte $N_D < 2 \cdot 10^{15}$ cm$^{-3}$) und hat eine Dicke von 1 bis 3 μm. Diese Absorptionsschicht 4 ist als Absorptionsschicht für die Photodiode vorgesehen. Auf der Absorptionsschicht 4 ist eine Photodiodenschicht 5 aus p-dotiertem InP bzw. InAlAs oder InGaAlAs mit einer Akzeptorendichte $N_A = 10^{16} ... 10^{18}$ cm$^{-3}$ und einer Dicke von 0,2 bis 1

μm aufgewachsen. Diese Photodiodenschicht 5 ist ebenfalls ganzflächig aufgewachsen und bildet zum einen das p-Gebiet der Photodiode und trennt zum anderen durch ihre Sperreigenschaft elektrisch die gesamten Photodioden-Schichten von den darauffolgenden FET-Schichten ab. Das Abschnürverhalten eines FETs wird durch diese untenliegende Photodiodenschicht 5 als Pufferschicht außerdem zusätzlich günstig beeinflußt (K. Steiner, U. Seiler, K. Heime:"Influence of p-InP buffer layers on submicron InGaAs/InP junction field-effect transistors", Appl. Phys. Lett.53, 2513-2515, (1988)). Diese Photodiodenschicht 5 ist im Bereich der Photodiode 16 soweit rückgeätzt, daß die Oberfläche der Absorptionsschicht 4 so weit freigelegt ist, wie für das Aufbringen eines Kontaktes auf der Absorptionsschicht 4 erforderlich ist.

Auf die Photodiodenschicht 5 ist im Bereich des FETs 15 eine Kanalschicht 6 aus z. B. InGaAs aufgewachsen. Diese Kanalschicht 6 des FETs ist n-leitend dotiert mit einer Donatorendichte von $N_D = 10^{16}...10^{18}$ cm$^{-3}$ und hat eine Dicke von 0,05 bis 2 μm. Durch die Dicke und die Dotierung dieser Kanalschicht 6 sind die Steilheit und das Abschnürverhalten des FETs bestimmt.

Als Gate des FETs ist eine Deckschicht 7 aus InP bzw. InAlAs oder InGaAlAs aufgewachsen. Diese Deckschicht ist p-leitend dotiert mit einer Akzeptorendichte von $N_A = 10^{16}...10^{18}$ cm$^{-3}$ und hat eine Dicke von 0,2 bis 1 μm. Diese Deckschicht 7 bildet ein Heterogate für den JFET. Alternativ kann diese Schicht n-leitend dotiert sein mit einer Donatorendichte von $N_D = 10^{14}... 10^{16}$ cm$^{-3}$ bei einer Dichte von etwa 0,5 μm. Damit kann bei Wahl eines geeigneten Kontaktmaterials für einen auf diese Deckschicht 7 aufgebrachten Gate-Kontakt ein MESFET realisiert werden. Die Kanalschicht 6 und die Deckschicht 7 sind nur im Bereich des FETs 15 aufgewachsen bzw. im Bereich der Photodiode 16 durch selektives Ätzen entfernt. Die Realisierung des Gatebereichs des FETs 15 und des p-Gebietes der Photodiode 16, d. h. die im Bereich der Photodiode 16 verbliebenen Anteile der Photodiodenschicht 5, kann durch eine selbstjustierende (self-aligned) Technologie, z. B. die T-Gate-Technik (D.Wake, A.W.Livingstone, D.A.Andrews, G.J.Davies: "A Self-aligned InGaAs Junction Field-Effect Transistor Grown by Molecular Beam Epitaxy" IEEE EDL-5, 285-287, (1984)) erfolgen. In jedem Fall ist die ganzflächige, p-leitend dotierte Schicht (Photodiodenschicht 5) strukturiert.

An der erfindungsgemäßen Photodiode-FET-Kombination sind ein erster Kontakt 9, der ringförmig ausgebildet ist, auf dem im Bereich der Photodiode 16 verbliebenen Anteil der Photodiodenschicht 5, ein zweiter Kontakt 12 im Bereich der Photodiode 16 auf der Absorptionsschicht 4, ein Gate-Kontakt 8 auf der Deckschicht 7, ein Drain-Kontakt 10 auf der Kanalschicht 6 und ein Source-Kontakt 11 auf der Kanalschicht 6 im Bereich von Drain bzw. Source aufgebracht. Eine innerhalb des ringförmigen ersten Kontaktes 9 der Photodiode 16 aufgebrachte Antireflexschicht 13 erhöht den Wirkungsgrad der Photodiode um etwa 30 %. Die Photodiode 16 und der FET 15 sind durch einen Trenngraben 14, der sich durch sämtliche Epitaxieschichten 2, 3, 4, 5, 6 bis in das Substrat 1 erstreckt, getrennt.

Alternativ zu dem Aufbringen der Sperrschichten 2, 3 kann zur Verbesserung der Isolationseigenschaft des Substrates 1 eine ganzflächige p-Diffusion oder p-Implantation in das semiisolierende InP-Substrat 1 vor der Epitaxie realisiert werden.

Wenn die semiisolierende Eigenschaft des Substrates 1 ausreicht oder mit der genannten Diffusion bzw. Implantation eine ausreichende Verbesserung der Isolationseigenschaft des Substrates 1 erzielt ist, kann auf die Sperrschichten 2, 3 verzichtet werden, ohne daß die prinzipielle Funktion des FETs 15 beeinträchtigt wird.

Der erfindungsgemäße Aufbau der Photodiode-FET-Kombination hat im Gegensatz zu dem Stand der Technik (z. B. pinFET-Strukturen wie in Y.Akahori, S.Hata u.a.: "Monolithic InP/GaInAs pinFET Receiver using MOMBE-Grown Crystal" Electronics Letters 25, 37-38, (1989) beschrieben) den Vorteil, daß die FET-Schichten mit den schwierig herzustellenden Strukturen im Mikro- und Submikrometer-Bereich bei dem erfindungsgemäßen Aufbau am weitesten oben liegen und somit eine Kontaktbelichtung bei der Photolithographie erlauben, wogegen die nur geringfügig tiefer liegende Photodioden-Struktur mit wesentlich größeren Toleranzen noch problemlos hergestellt werden kann. Auch beträgt bei dem erfindungsgemäßen Aufbau die Stufe zwischen Feldeffekttransistor und Photodiode bei den üblichen Dotierungshöhen nur ca. 0,5 bis 0,6 μm, während z. B. bei der in D.A.H.Spear, P.J.G.Dawe,G.R.Antell, W.S.Lee, S.W. Bland: "New Fabrication Technology for Lang-Wavelength Receiver OEICs" Electronics Letters 25, 156-157, (1989) veröffentlichten Struktur Halbleiterstufen von 2 bis 3 μm notwendig sind.

**Ansprüche**

1. Monolithisch integrierte Photodiode-FET-Kombination auf einem Substrat (1) mit einer Absorptionsschicht (4), einer für elektrische Leitung eines ersten Leitungstyps dotierten Kanalschicht (6), einer Deckschicht (7) als Gate, einem Drain-Kontakt (10), einem Source-Kontakt (11), einem Gate-Kontakt (8), einem ersten Kontakt (9) und einem zweiten Kontakt (12) für die Photodiode (16), **dadurch gekennzeichnet,**

- daß die Absorptionsschicht (4) ganzflächig aufgewachsen ist,
- daß auf der Absorptionsschicht (4) der zweite Kontakt (12) und eine für elektrische Leitung eines entgegengesetzten zweiten Leitungstyps dotierte Photodiodenschicht (5) aufgebracht sind,
- daß im Bereich der Photodiode (16) auf dieser Photodiodenschicht (5) der erste Kontakt (9) ringförmig aufgebracht ist,
- daß innerhalb dieses ringförmigen ersten Kontaktes (9) eine Antireflexschicht (13) auf der Photodiodenschicht (5) aufgebracht ist,
- daß im Bereich des FET (15) auf der Photodiodenschicht (5) die Kanalschicht (6) und darauf die Deckschicht (7) aufgebracht sind und
- daß die Photodiode (16) und der FET (15) durch einen Trenngraben (14) getrennt sind.

2. Photodiode-FET-Kombination nach Anspruch 1,

**dadurch gekennzeichnet,**

daß zwischen dem Substrat (1) und der Absorptionsschicht (4) eine für den zweiten Leitungstyp dotierte erste Sperrschicht (2) und auf der dem Substrat (1) abgewandten Seite dieser ersten Sperrschicht (2) eine für elektrische Leitung des ersten Leitungstyps dotierte zweite Sperrschicht (3) aufgewachsen sind.

3. Photodiode-FET-Kombination nach Anspruch 1 oder 2,

**dadurch gekennzeichnet,**

daß der erste Leitungstyp n-Leitung und der zweite Leitungstyp p-Leitung ist.

4. Photodiode-FET-Kombination nach Anspruch 1 oder 2,

**dadurch gekennzeichnet,**

daß der erste Leitungstyp p-Leitung und der zweite Leitungstyp n-Leitung ist.